(19) Europäisches Patentamt
European Patent Office
Office européen des brevets

(11) **EP 1 432 120 B1**

(12) **EUROPEAN PATENT SPECIFICATION**

(45) Date of publication and mention
of the grant of the patent:
**20.10.2010 Bulletin 2010/42**

(51) Int Cl.:
***H03F 1/02*** *(2006.01)*

(21) Application number: **03028467.3**

(22) Date of filing: **12.12.2003**

(54) **Audio power amplifier**

Audioleistungsverstärker

Amplificateur de puissance audio

(84) Designated Contracting States:
**AT BE BG CH CY CZ DE DK EE ES FI FR GB GR HU IE IT LI LU MC NL PT RO SE SI SK TR**

(30) Priority: **17.12.2002 IT RE20020097**
**17.12.2002 IT RE20020098**

(43) Date of publication of application:
**23.06.2004 Bulletin 2004/26**

(60) Divisional application:
**09015298.4 / 2 180 594**

(73) Proprietor: **Ask Industries S.p.A.**
**I-42100 Reggio Emilia (IT)**

(72) Inventors:
• **Franceschini, Giovanni**
**42100 Reggio Emilia (IT)**

• **Bellini, Alberto**
**42100 Reggio Emilia (IT)**
• **De Benedetti, Antonio**
**42100 Reggio Emilia (IT)**
• **Burlenghi, Michele**
**43019 Soragna (Parma) (IT)**
• **Ugolotti, Emanuele**
**42100 Reggio Emilia (IT)**

(74) Representative: **Lecce, Giovanni**
**Dott. Giovanni Lecce & C. S.r.l.**
**Via Fratelli Ruffini, 9**
**20123 Milano (IT)**

(56) References cited:
DE-A- 19 947 808    US-A- 4 346 349
US-A- 5 329 245    US-A- 5 905 407

**Description**

The present invention refers to an audio power amplifier.

As it is known, the audio power amplifiers are already widely used in various consumer electronics fields.

Switching amplifiers have recently become popular for their high performance and manufacturing at low costs.

As input, the switching amplifiers (that are also known as Class D amplifiers) receive a modulated PWM (Pulse width Modulation) signal; in order to obtain the amplification, this input is used to choke a high level voltage equal to the available supply voltage causing, in the output voltage, a high ripple turning into a high harmonic distortion of the sound produced by the loudspeaker.

Moreover the bandwidth of the switching (Class D) amplifiers is bound to the PWM modulation frequency that, due to the limited switching speed of the static switches cannot be high.

It follows that, for a switching amplifier, to a high performance, a significant distortion is opposed and therefore the difficulty in obtaining a high bandwidth.

On the other hand, the distortion of the linear amplifiers that are commonly used (known in the art as Class A, AB and B amplifiers) is relatively low, but their efficiency is definitely lower than the Class D ones.

The Class D (switching) amplifiers have the advantage of a high performance, i.e. they have a high ratio between the power actually supplied on the load and the one actually absorbed by the supply, but they have a limited bandwidth and their distortion increases as the signal frequency increases. Moreover, Class D amplifiers show a considerable distortion when the signal width to be amplified is lower than a threshold that, in its turn, depends on the switching frequency, the modulator topology and some intrinsic parameters (time constants of charging/discharging and transfer times) in the switching elements [MOSFET (Metal Oxide Silicon Field Effect Transistor), IGBT (Insulated Gate Bijunction Transistor)].

Linear amplifiers are instead characterized by very low distortions, high bandwidth (starting from, in decreasing order, Class A, Class AB and Class B) but they have a very low efficiency (starting from in decreasing order, Class B, Class AB, Class A).

Nowadays, many solutions can be found both in the art and in the market in order to solve:

- the efficiency problem for the linear amplifiers,
- the distortion problem in Class D amplifiers,
- the bandwidth limitation problem in Class D amplifiers.

But these solutions are, predominantly, separate between them, i.e. they keep the linear amplifiers separate from the switching (Class D) ones.

However, composite linear/switching amplifiers are also known in the art, see US5329245, US4346349, and US5905407, the former of which using magnetic summing, the two latter using electric summing of the linear and switching amplifier output currents.

Object of the present invention is to remove the above-mentioned drawbacks.

According to the present invention these and other purposes resulting from the following description will be achieved by an audio power amplifier characterized in that it is achieved with a hybrid architecture constituted by the magnetic coupling of a linear amplifier ($Hd_{lin}$) with a switching amplifier ($Hd_{sw}$).

In a first solution wherein said elements are magnetically coupled ("Magnetic Tandem") an audio power amplifier characterized by the low distortion of a linear amplifier and by the high efficiency of a switching is obtained; the whole system obtained has a higher efficiency than the linear amplifier. This purpose is obtained by magnetically coupling a linear audio amplifier and a switching audio amplifier on the mobile coil of a loudspeaker; A loudspeaker with two coaxially wrapped coils is used, the two coils are separately controlled: one with a linear amplifier and the other one with a switching amplifier.

The invention is described in detail here below, according to the above-mentioned embodiments which are given only by way of non-limitative example wherein reference is made to attached drawings:

Figure 1 represents the principle scheme of an amplifier with magnetic coupling "Magnetic Tandem" and double coil loudspeaker,

Figure 2 represents the current waveform in a double coil loudspeaker powered by the "Magnetic Tandem" amplifier, compared with the current waveform in a linear amplifier and in a switching one,

Figure 3 represents the circuit scheme of the "Magnetic Tandem" amplifier,

Figure 4 represents the diagram of the distortion waveform according to the frequency, with equal power on a purely resistive load, on a double coil loudspeaker equipped with the "Magnetic Tandem" amplifier compared with the one of a switching (Class D) amplifier,

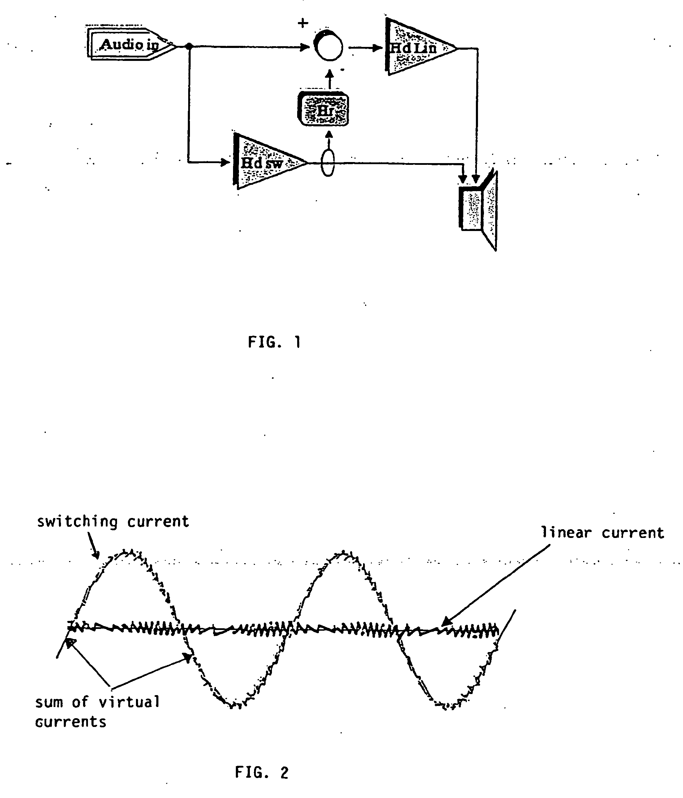

With reference to the scheme represented in Figure 1 concerning the solution of an amplifier with "Tandem Magnetic" magnetic coupling, the current on the coil pertaining to the switching amplifier is fed back, if it is picked up by means of a shunt in series and through a block with transfer function $Hr(\omega)$, on the linear amplifier having transfer function $Hd_{lin}(\omega)$.

The transfer function $Hr(\omega)$ has a particular waveform in frequency, expands the bandwidth and it also connects the current to the coil pertaining to the switching amplifier and to the input signal.

The switching amplifier with the transfer function $Hd_{sw}(\omega)$ acts as voltage generator and it is directly controlled by the audio input signal.

On the contrary, the linear amplifier $Hd_{lin}$ compensates the current ripples that are unavoidably produced by the switching amplifier $Hd_{sw}$.

The current system was fed back in a way similar to the one used in the torque control of the electric machines wherein the current ring is closed in order to control the torque. In fact, the torque of an electric machine is proportional to the current flowing in the stator (asynchronous motors) or in the rotor (continuous current motors): if the current can be modulated, the torque is also proportionally modulated; moreover there is no bind with the loading conditions of the motor and this does not occur in the usual operations wherein the voltage or the power frequency are modulated.

If the same action is carried out on the loudspeaker, the current supplied by the amplifier id independent from the voltage-current transfer function of the load being the admittance of the same load. Let's suppose that $V_{out}(\omega)$ is the output voltage of the amplifier, $I_{out}(\omega)$ the output current of the amplifier and $Z_{out}(\omega)$ the load impedance i.e. the electric impedance of the loudspeaker (with $Y_{out}(\omega)$ the relevant admittance):

$$\frac{\vec{I}_{OUT}(\omega)}{\vec{V}_{OUT}(\omega)} = \frac{1}{\vec{Z}_{OUT}(\omega)} = \vec{Y}_{OUT}(\omega)$$

The impedance of the loudspeaker $Z_{out}(\omega)$ is not constant in frequency and therefore would introduce a distortion.

Checking the current means checking the mechanical force applied to the loudspeaker cone (according to the mentioned analogy relevant to the torque control of electric machines). There is in fact a direct proportionality between the force by which the loudspeaker cone moves, i.e. the sound pressure, and the current flowing into the coil:

$$F = (B \cdot l) \cdot I_{OUT}$$

wherein with (B.1) means the factor force of the loudspeaker, defined as the magnetic flux density multiplied by the length of the mobile coil.

In Figure 2 the currents flowing in the hybrid amplifier according to the present invention excited by a sinusoidal input are shown: it can be particularly noticed that the output current of the linear amplifier (linear current) acts as a real compensation of the output current of the switching amplifier (switching current) showing a sinusoidal waveform with an overlapped ripple due to the intrinsic distortion of the switching amplifier.

The combination of the currents that now is magnetically taking place, i.e. it takes place through the combination of the magnetic fields they generated, is detected as a "virtual" combination, i.e. as if it is one current flowing in one single coil, considering the reciprocal effect between the two currents being actually present.

As it can be noticed, this current does not have distortions and it takes a sinusoidal waveform reproducing, without the waveforms unavoidably generated by the switching amplifier $Hd_{sw}$, the sinusoidal curve of the current generated by the magnetic field inside the loudspeaker. Moreover the "virtual current" is proportional to the input signal, i.e. to the signal to be reproduced.

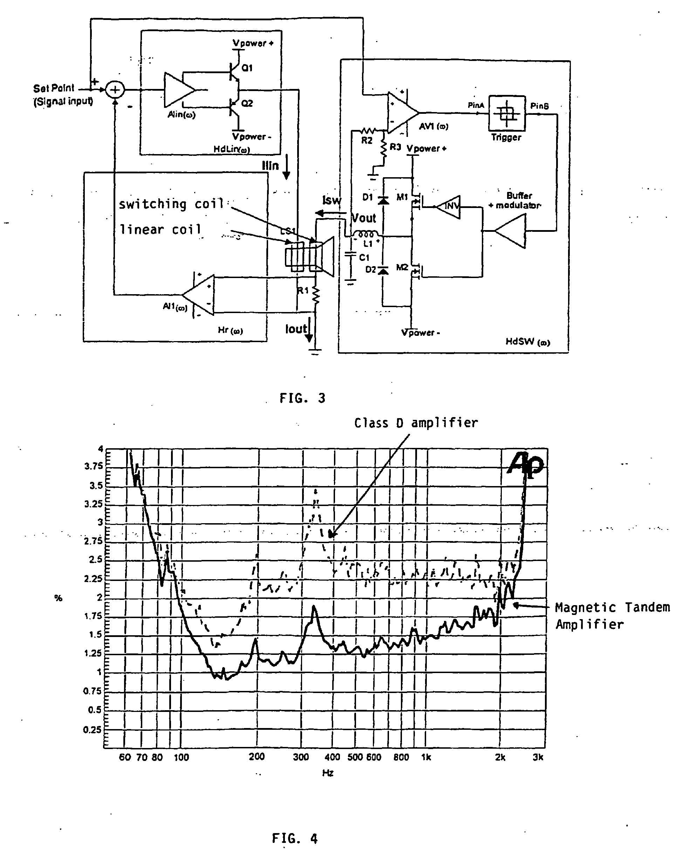

In Figure 3 the wiring diagram of the "Magnetic Tandem" amplifier according to the present invention is shown. The linear amplifier $Hd_{lin}$ supplies the current $I_{lin}$ that is sent to the coil pertaining to it of the loudspeaker LS1, while the switching amplifier $Hd_{sw}$ supplies the current $I_{sw}$ and the tension $V_{out}$ on the coil pertaining to it, of the loudspeaker LS1, by means of two power switching elements M1, M2 (usually power MOSFET). The gain of the switching amplifier $Hd_{sw}$ is determined by two resistances R2, R3. The magnetic fields determined by the two currents $I_{lin}$ and $I_{sw}$ sum up in the loudspeaker air gap thus supplying a magnetic field being proportional to the current $I_{out}$ and exactly corresponding to the sum of the two currents $I_{lin}$ and $I_{sw}$. The current $I_{sw}$ is then fed back through a shunt R1 and a differential amplifier AI1 (i.e. $Hr(\omega)$): the output signal of the differential amplifier is subtracted to the input signal and the result is sent to the input of the linear amplifier $Hd_{lin}$. The combination of the currents $I_{lin}$ and $I_{sw}$ giving as a result the current $I_{out}$ is highlighted in Figure 2 wherein $I_{lin}$ is the "linear current", $I_{sw}$ is the "switching current" and $I_{out}$ is the "virtual current" that creates in the air gap of the loudspeaker LS1.

The feedback of the current $I_{sw}$ through the transfer function $Hr(\omega)$ allows the linear amplifier, with transfer function $Hd_{lin}(\omega)$ to act in such a way that the current $I_{out}(\omega)$ follows the input voltage (Set point) as much as possible. In particular, by this feedback, the error signal allowing the linear amplifier $Hd_{lin}$ to generate an output current $I_{lin}$ containing both a portion of the useful current $I_{out}$ and the replica, exactly in push-pull, of the ripple unavoidably generated by the switching amplifier $Hd_{sw}$ is generated.

Figure 4 shows the total harmonic distortion plus noise THD+N (Total Harmonic Distortion + Noise) according to the frequency and with the same power on a double coil loudspeaker of a "Magnetic Tandem" amplifier, compared with the one of a switching (Class D) amplifier. It can be deduced that the "Magnetic Tandem" amplifier keeps the linear amplifier distortion low, together with the high efficiency of the switching amplifier.

The measurements are made in an anechoic chamber on a DIN 51435 baffle.

**Claims**

1. A hybrid architecture audio power amplifier receiving an input signal (Audio in) and feeding a load, said amplifier comprising:

   - a linear amplifier (Hdlin);
   - a switching amplifier (Hdsw);
   - a magnetic coupling circuit connecting the outputs of said linear and switching amplifiers (Hdlin, Hdsw);

   **characterized in that** said magnetic coupling circuit comprises a loudspeaker (LS1) provided with two coaxial coils, the output current (Ilin) supplied by said linear amplifier (Hdlin) being sent to one of the coils of said loudspeaker (LS1) and the output current (Isw) supplied by said switching amplifier (Hdsw) being supplied to the other coil of said loudspeaker (LS1) and fed back to the input signal, making it proportional to said input signal (Audio in).

2. The audio power amplifier according to claim 1, **characterized in that** said output current (Isw) and the output voltage (Vout) of said switching amplifier (Hdsw) are supplied to said other coil of said loudspeaker (LS1) through two power switching elements (M1, M2).

3. The audio power amplifier according to claims 1 or 2, **characterized in that** the current on the coil pertaining to said switching amplifier (Hdsw) is fed back to said linear amplifier (Hdlin) through a block having a transfer function $Hr(\omega)$ and comprising a shunt (R1) and a differential amplifier (AI1).

4. The audio power amplifier according to claims 1 to 3, **characterized in that** the gain of said switching amplifier (Hdsw) is determined by two resistances (R1, R2).

5. The audio power amplifier according to claims 1 to 4, **characterized in that** the magnetic fields generated by said output currents of said output current (Ilin) of said linear amplifier (Hdlin) and said output current (Isw) of said switching amplifier (Hdsw) sum up in the air gap of said loudspeaker (LS1), thus providing a magnetic field proportional to the current Iout corresponding to the sum of said two currents (Ilin and Isw).

6. The audio power amplifier according to the preceding claims, **characterized in that** said output current is independent from the voltage-current transfer function of said load.

7. The audio power amplifier according to the preceding claims, **characterized in that** said switching amplifier (Hdsw) having the transfer function $Hdsw(\omega)$ acts as voltage generator and is directly controlled by said input audio signal (Audio in).

8. The audio power amplifier according to the preceding claims, **characterized in that** said linear amplifier (Hdlin) acts as a compensator of the current ripple produced by said switching amplifier (Hdsw).

9. The audio power amplifier according to the preceding claims, **characterized in that** the signal generated by said linear amplifier (Hdlin) which comprises an error signal derived from the feedback, generates an output current ($I_{lin}$)containing both a portion of the useful current ($I_{out}$) and the replica, in push-pull, of the ripple generated by said switching amplifier (Hdsw).

**Patentansprüche**

1. Hybridarchitektur-Audioeistungsverstärker, welcher ein Eingangssignal (Audio in) empfängt und eine Last zuführt, wobei der Verstärker umfasst:

   - einen Linearverstärker (Hdlin);
   - einen Schaltverstärker (Hdsw);
   - einen Magnetkopplungs-Schaltkreis, welcher die Ausgänge der Linear- und Schaltverstärkes (Hdlin, Hdsw) verbindet;

   **dadurch gekennzeichnet, dass** der Magnetkopplungs-Schaltkreis einen Lautsprecher (LS1) umfasst, welcher mit zwei Koaxialspulen versehen ist, wobei der Ausgangsstrom (Ilin), der durch den Linearverstärker (Hdlin) zugeführt wird, zu einer der Spulen der Lautsprecher (LS1) gesendet wird, und der Ausgangsstrom (Isw), der durch den Schaltverstärker (Hdsw) zugeführt wird, zu der anderen Spule des Lautsprechers (LS1) zugeführt wird und zu dem Eingangssignal rückgeführt wird, wobei dieses proportional zu dem Eingangssignal (Audio in) gemacht wird.

2. Audioleistungsverstärker nach Anspruch 1, **dadurch gekennzeichnet, dass** der Ausgangsstrom (Isw) und die Ausgangsspannung (Vout) des Schaltverstärkers (Hdsw) zu der anderen Spule des Lautsprechers (LS1) durch zwei Leistungsschaltelemente (M1, M2) zugeführt wird.

3. Audioleistungsverstärker nach Anspruch 1 oder 2, **dadurch gekennzeichnet, dass** der Strom auf der Spule, welche zu dem Schaltverstärker (Hdsw) gehört, zu dem Linearverstärker (Hdlin) über einen Block zurückgeführt wird, welcher eine Übertragungsfunktion Hr(w) aufweist und einen Shunt (R1) und einen Differenzialverstärker (AI1) umfasst.

**4.** Audioleistungsverstärker nach Ansprüchen 1 bis 3, **dadurch gekennzeichnet, dass** die Verstärkung des Schaltverstärkers (Hdsw) durch zwei Widerstände (R1, R2) bestimmt wird.

**5.** Audioleistungsverstärker nach Ansprüchen 1 bis 4, **dadurch gekennzeichnet, dass** die Magnetfelder, welche durch die Ausgangsströme des Ausgangsstroms (Ilin) des Linearverstärkers (Hdlin) und des Ausgangsstroms (Isw) des Schaltverstärkers (Hdsw) sich in dem Luftspalt des Lautsprechers (LS1) aufsummieren, wodurch ein Magnetfeld proportional zu dem Strom Iout entsprechend der Summe der zwei Ströme (Ilin und Isw) bereitgestellt wird.

**6.** Audioleistungsverstärker nach den vorhergehenden Ansprüchen, **dadurch gekennzeichnet, dass** der Ausgangsstrom unabhängig von der Spannungs-StromÜbertragungsfunktion der Last ist.

**7.** Audioleistungsverstärker nach den vorhergehenden Ansprüchen, **dadurch gekennzeichnet, dass** der Schaltverstärker (Hdsw) mit der Übertragungsfunktion Hdsw(w) als Spannungserzeuger arbeitet und direkt durch das Eingangsaudiosignal (Audio in) gesteuert wird.

**8.** Audioleistungsverstärker nach den vorhergehenden Ansprüchen, **dadurch gekennzeichnet, dass** der Linearverstärker (Hdlin) als ein Kompensator der Stromwelligkeit arbeitet, welche durch den Schaltverstärker (Hdsw) erzeugt wird.

**9.** Audioleistungsverstärker nach den vorhergehenden Ansprüchen, **dadurch gekennzeichnet, dass** das durch den Linearverstärker (Hdlin) erzeugte Signal, welches ein Fehlersignal umfasst, dass aus der Rückkopplung abgeleitet ist, einen Ausgangsstrom ($I_{lin}$) erzeugt, welcher sowohl einen Abschnitt des verwendbaren Stroms ($I_{out}$) wie auch des Replikats enthält, dies im Gegentakt, der durch den Schaltverstärker (Hdsw) erzeugten Welligkeit.

**Revendications**

**1.** Amplificateur de puissance audio à architecture hybride recevant un signal d'entrée (Audio in) et alimentant une charge, ledit amplificateur comprenant:

- un amplificateur linéaire (Hdlin);
- un amplificateur commutateur (Hdsw); et
- un circuit de couplage magnétique connectant les sorties desdits amplificateurs linéaire et commutateur (Hdlin, Hdsw);

**caractérisé en ce que** ledit circuit de couplage magnétique comprend un haut-parleur (LS1) incluant deux bobines coaxiales, le courant de sortie (Ilin) fourni par ledit amplificateur linéaire (Hdlin) étant envoyé à une première des bobines dudit haut-parleur (LS1) et le courant de sortie (Isw) fourni par ledit amplificateur commutateur (Hdsw) étant fourni à l'autre bobine dudit haut-parleur (LS1) et réinjecté dans le signal d'entrée, le rendant proportionnel audit signal d'entrée (Audio in).

**2.** Amplificateur de puissance audio selon la revendication 1, **caractérisé en ce que** ledit courant de sortie (Isw) et la tension de sortie (Vout) dudit amplificateur commutateur (Hdsw) sont fournis à ladite autre bobine dudit haut-parleur (LS1) à travers deux éléments de commutation de puissance (M1, M2).

**3.** Amplificateur de puissance audio selon la revendication 1 ou 2, **caractérisé en ce que** le courant sur la bobine correspondant audit amplificateur commutateur (Hdsw) est réinjecté dans ledit amplificateur linéaire (Hdlin) à travers un bloc possédant une fonction de transfert Hr(w) et comprenant un shunt (R1) et un amplificateur différentiel (A|1).

**4.** Amplificateur de puissance audio selon l'une quelconque des revendications précédentes, **caractérisé en ce que** le gain dudit amplificateur commutateur (Hdsw) est déterminé par deux résistances (R1, R2).

**5.** Amplificateur de puissance audio selon l'une quelconque des revendications précédentes, **caractérisé en ce que** les champs magnétiques générés par ledit courant de sortie (Ilin) dudit amplificateur linéaire (Hdlin) et ledit courant de sortie (Isw) dudit amplificateur commutateur (Hdsw) s'additionnent dans l'entrefer dudit haut-parleur (LS1) en générant ainsi un champ magnétique proportionnel au courant (Iout) correspondant à la somme desdits deux courants (Ilin et Isw).

**6.** Amplificateur de puissance audio selon l'une quelconque des revendications précédentes, **caractérisé en ce que** ledit courant de sortie est indépendant de la fonction de transfert tension - courant de ladite charge.

**7.** Amplificateur de puissance audio selon l'une quelconque des revendications précédentes, **caractérisé en ce que** ledit amplificateur commutateur (Hdsw) à fonction de transfert Hdsw(w) agit comme générateur de tension et est directement réglé par ledit signal d'entrée audio (Audio in).

**8.** Amplificateur de puissance audio selon l'une quelconque des revendications précédentes, **caractérisé en ce que** ledit amplificateur linéaire (Hdlin) agit comme compensateur de l'ondulation de courant produite par ledit amplificateur commutateur (Hdsw).

**9.** Amplificateur de puissance audio selon l'une quelconque des revendications précédentes, **caractérisé en ce que** le signal généré par ledit amplificateur linéaire (Hdlin), qui comprend un signal d'erreur dérivé de la réinjection, génère un courant de sortie (Ilin) contenant tant une partie du courant utile (Iout) que la réplique, en push-pull, de l'ondulation générée par ledit amplificateur commutateur (Hdsw).

FIG. 1

switching current

linear current

sum of virtual currents

FIG. 2

FIG. 3

FIG. 4

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 5329245 A
- US 4346349 A

- US 5905407 A